# FASCICULE DE BREVET EUROPEEN

(11) **EP 0 985 155 B1**
(45) Date de publication et mention de la délivrance du brevet: **24.07.2002**
(21) Numéro de dépôt: 98928399.9
(22) Date de dépôt: 29.05.1998
(51) Int. Cl.: G01R 31/28, G06F 15/00, B64F 5/00

(54) **PROCEDE ET DISPOSITIF DE TEST POUR EQUIPEMENTS ELECTRONIQUES**
VERFAHREN UND VORRICHTUNG ZUR PRÜFUNG VON ELEKTRONISCHEN EINRICHTUNGEN
METHOD AND DEVICE FOR TESTING ELECTRONIC EQUIPMENT

(30) Priorité: 30.05.1997 FR 9706684
(43) Date de publication de la demande: 15.03.2000
(73) Titulaire: THALES AVIONICS S.A., 78141 Vélizy Villacoublay Cédex (FR)
(72) Inventeur: CLAVERIE, Serge, Thomson-CSF P.I., Prot. & Conseil, 94117 Arcueil Cedex (FR)
(74) Mandataire: Guérin, Michel
(86) Numéro de dépôt international: FR9801092
(87) Numéro de publication internationale: WO9854587

(56) Documents cités:
- EP-A- 0 557 628
- WO-A-96/37839
- FR-A- 2 658 933
- GB-A- 2 272 314
- US-A- 5 111 402
- MASCIOLA J A ET AL: "A SOFTWARE ARCHITECTURE FOR MIXED SIGNAL FUNCTIONAL TESTING" PROCEEDINGS OF THE INTERNATIONAL TEST CONFERENCE, WASHINGTON, OCT. 2 - 6, 1994, 2 octobre 1994, pages 580-586, XP000520019 INSTITUTE OF ELECTRICAL AND ELECTRONICS ENGINEERS

## Description

La présente invention concerne un procédé et un dispositif de test pour équipements électroniques, plus particulièrement destiné à être utilisé dans le domaine de l'avionique pour tester les organes d'un aéronef, ces organes étant pilotés par au moins un calculateur.

En phase de production, les équipements électroniques des aéronefs doivent passer avec succès, de manière contractuelle, des tests de recette avant de pouvoir être mis sur le marché. Ces tests sont connus sous la dénomination ATP pour la dénomination anglaise de "Acceptance Test Procedure".

En phase d'exploitation, les équipements électroniques doivent aussi subir des tests, lors de détection de défaillance, de manière à identifier la panne et à localiser le ou les composants responsables. Ces équipements électroniques ayant une durée de vie relativement longue, de l'ordre de vingt ans, ils sont aussi amenés à passer des tests de validation pour vérifier qu'ils répondent toujours aux réglementations en cours. Ces réglementations changent en fonction des évolutions technologiques.

En phase de conception, le constructeur est amené à effectuer des tests pour vérifier que l'équipement en cours d'élaboration possède bien les fonctionnalités attendues et que l'équipement électronique interagissant avec d'autres répond bien au cahier des charges.

En phase de conception et de production les tests ont lieu chez le constructeur et en phase d'exploitation, ils peuvent avoir lieu chez le constructeur, si l'équipement électronique est débarqué de l'aéronef et retourné, ou dans des stations de test agréées que possèdent les principales compagnies aériennes.

Ces différents tests sont des étapes absolument nécessaires dans un domaine où un niveau de sécurité très élevé est requis.

Au cours de sa vie, un équipement électronique subira plusieurs tests à l'aide de dispositifs de tests différents, selon la phase dans laquelle il se trouve, sans qu'il n'y ait de liaison entre les différents dispositifs de tests et entre les résultats des tests passés et du test en cours.

De la même manière, un dispositif de test particulier sera utilisé pour tester de manière indépendante plusieurs équipements similaires qui sont dans la même phase de leur existence. Pour chaque équipement, on sauvegarde les résultats des tests, mais il n'y a pas d'interactivité entre les résultats des tests passés par plusieurs équipements électroniques similaires.

Un dispositif de test classique comporte un interpréteur relié à un banc de test lui-même relié à l'équipement électronique. Le dispositif de test reçoit en langage machine, une liste de commandes ou spécifications de test. Le dispositif de test, à partir de ces commandes, pilote le banc de test qui applique des stimulis aux composants électroniques de l'équipement et effectue des mesures. Un opérateur vérifie si ces mesures correspondent au résultat escompté. Des oscilloscopes multimètres ou autres appareils de mesure sont à la disposition de l'opérateur.

En cas de défaillance, plusieurs séries de tests complémentaires sont à disposition pour essayer de détecter l'origine de la défaillance.

La liste des commandes en langage machine est établie par un opérateur codeur à partir d'une liste de commandes dans un langage plus élaboré et familier au technicien qui demande le test. Les techniciens ont des langages propres à leur discipline.

Le document FR-A-2 658 933 décrit un procédé et un dispositif de test d'un équipement électronique relié à un calculateur couplé à une console d'affichage et d'entrée de données avec un écran réalisant une interface avec un opérateur, le test comprenant une liste de commandes à exécuter. Ce procédé et ce dispositif impliquent en outre l'affichage d'une feuille de test sur l'écran, formée d'un groupe de cellules associé à une commande, ce groupe comportant
- une cellule qui est à renseigner avec un type de la commande,
- une cellule qui est à renseigner avec un résultat attendu de la commande, et
- une cellule qui est réservée à un résultat effectif de la commande.

Les risques d'introduire des erreurs, notamment de syntaxe, dans les programmes de test au niveau de leur écriture en langage élaboré et/ou de leur codage ne sont pas négligeables et le temps de mise au point d'un test est souvent très long suite aux nombreuses corrections, les fautes n'étant détectées que lorsque tout le test s'est déroulé.

Dans le domaine de l'avionique, l'activité test est une activité absolument nécessaire mais elle est très coûteuse puisque plusieurs types de dispositifs de tests cohabitent, puisque l'intervention humaine est un facteur important, et puisque en cas de défaillance, de nombreuses investigations sont généralement entreprises avant de pouvoir en détecter la cause.

La présente invention vise à réduire les coûts de l'activité de test en proposant un dispositif de test unique, capable de réaliser les tests d'un équipement électronique tout au long de son existence. Ce dispositif de test est aisé d'utilisation car l'opérateur effectuant le test peut dialoguer avec lui dans son propre langage. Le transcodage est supprimé et le temps de mise au point réduit car l'exécution du test peut se faire commande par commande.

Plus précisément la présente invention propose un procédé de test d'un équipement électronique relié à un calculateur couplé à une console d'affichage et d'entrée de données avec un écran réalisant un interface avec un opérateur. Un test comprend une liste de commandes à exécuter. Il consiste à afficher une feuille de test sur l'écran formée de groupes de cellules, un groupe étant associé à une commande. Pour au moins une commande, le groupe de cellules associé comporte une cellule à renseigner avec un libellé de la commande, une cellule à renseigner avec un résultat attendu de la commande, une cellule réservée au résultat effectif de la commande, une cellule réservée au résultat d'une comparaison entre le résultat effectif et le résultat attendu.

Il consiste ensuite à afficher, après l'exécution de la commande, le résultat effectif et le résultat de la comparaison.

Pour simplifier la saisie, chaque libellé est associé à un type de commande et le groupe de cellules peut comporter une cellule à renseigner avec le type de commande, le renseignement de cette cellule faisant apparaître le libellé associé dans la cellule du groupe à renseigner avec le libellé.

Pour faire gagner du temps et rendre plus sûre la saisie, la sélection d'une cellule à renseigner avec le type de commande, donne accès à un dictionnaire contenant une liste de types de commandes et pour chaque type le libellé associé.

Un libellé comporte au moins un argument et un argument est soit de type paramètre indépendant de l'équipement à tester, soit de type variable dépendant de l'équipement à tester.

Pour faciliter encore la saisie, en cas de sélection d'une cellule à renseigner avec un libellé ayant un argument de type variable, le procédé peut donner accès à une base de données associant la variable aux différentes valeurs qu'elle peut prendre.

Pour permettre à un opérateur quelque soit sa spécialité de réaliser le test, les valeurs d'une variable s'expriment différemment selon un identificateur que choisit un opérateur cet identificateur étant fonction de la spécialité de l'opérateur.

Pour faciliter l'identification des erreurs de syntaxe et des commandes défaillantes, le groupe de cellules peut comporter une cellule à renseigner avec un pas de la commande.

Il est intéressant de pouvoir sauvegarder le contenu des cellules d'un groupe après l'exécution d'une commande. Des traitements peuvent être effectués à partir des sauvegardes.

En cas de différence entre le résultat effectif et le résultat attendu d'une commande, il est avantageux de disposer d'au moins un test complémentaire contenu dans une bibliothèque de tests complémentaires.

L'accès à une base de données de localisation de panne peut être prévu. Cette base de données regroupe des sauvegardes de commandes relatives à des équipements électroniques précédemment testés dont au moins une zone présentait une défaillance et établit un lien entre la zone défaillante et au moins une commande pour laquelle existe une différence entre le résultat effectif et le résultat attendu.

Certains équipements électroniques nécessitent l'intervention de l'opérateur pour réaliser le test. Le procédé consiste alors à afficher sur l'écran une représentation d'au moins une partie de l'équipement à tester et à signaler à l'opérateur l'intervention à réaliser en la matérialisant sur la représentation.

La présente invention concerne également un dispositif de test d'un équipement électronique selon la revendication 12.

D'autres caractéristiques et avantages de l'invention apparaîtront à la lecture de la description qui suit illustrée par les figures qui représentent :
- la figure 1 un schéma d'un exemple de dispositif de test selon l'invention dans son environnement,
- la figure 2 un exemple de feuille de test après l'exécution des commandes ;
- la figure 3 un exemple des différentes valeurs de la variable ANI2 selon ses identificateurs ;
- la figure 4a un exemple de fenêtre apparaissant lorsque la fonction "coller une commande" est activée ;
- les figures 4b, 4c deux exemples de fenêtre apparaissant lorsque la fonction "coller une variable" est activée en fonction de l'identificateur choisi;
- la figure 4d un exemple de fenêtre apparaissant lorsque la fonction "coller le résultat attendu" est activée ;
- la figure 5a une représentation d'une partie d'un poste de commande telle que l'écran l'affiche ;
- la figure 5b une feuille de test partielle correspondant au test de la partie représentée à la figure 5a.

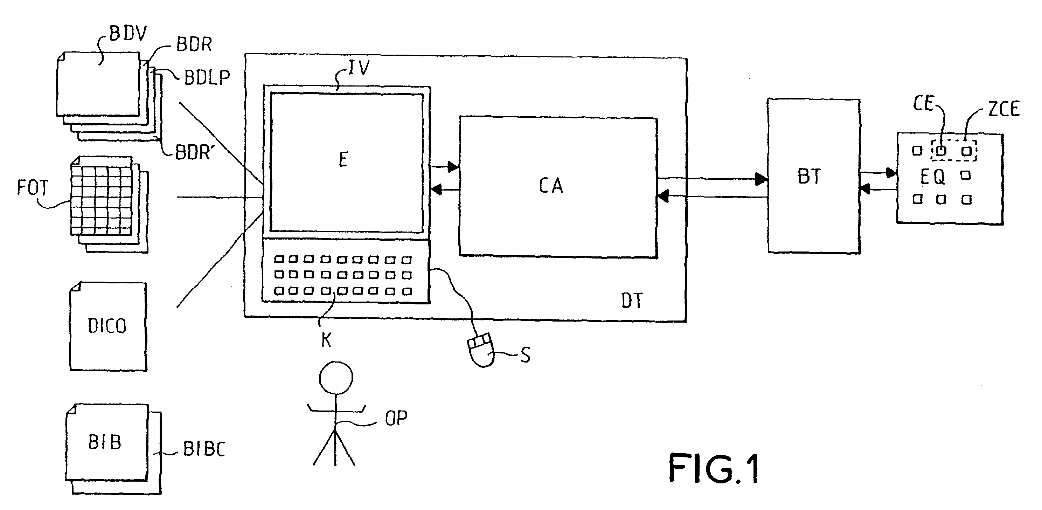

La figure 1 représente de manière schématique un dispositif de test DT conforme à l'invention. Ce dispositif de test DT est destiné à réaliser des tests sur des équipements électroniques EQ et notamment à tester les calculateurs d'un aéronef ou les différentes parties de son poste de commande.

Le dispositif de test DT comporte un calculateur CA relié à l'équipement électronique EQ et couplé à une console IV d'affichage et d'entrées de données qui sert d'interface avec un opérateur OP. L'opérateur OP dialogue avec le dispositif de test DT par l'intermédiaire de la console IV. Cette console IV comporte de manière classique un écran E d'affichage et un clavier K et/ou une souris S pour l'entrée des données. Dans l'exemple représenté la liaison entre l'équipement électronique EQ et le dispositif de test DT se fait par un banc de test BT.

En début de phase de préparation du test, l'écran E de la console IV d'affichage présente une feuille de test FOT vide comprenant plusieurs groupes de cellules C1 à C6. Un groupe de cellules C1 à C6 est associé à une commande. Chacune de ces cellules C1 à C6 représente un champ spécifique à la commande.

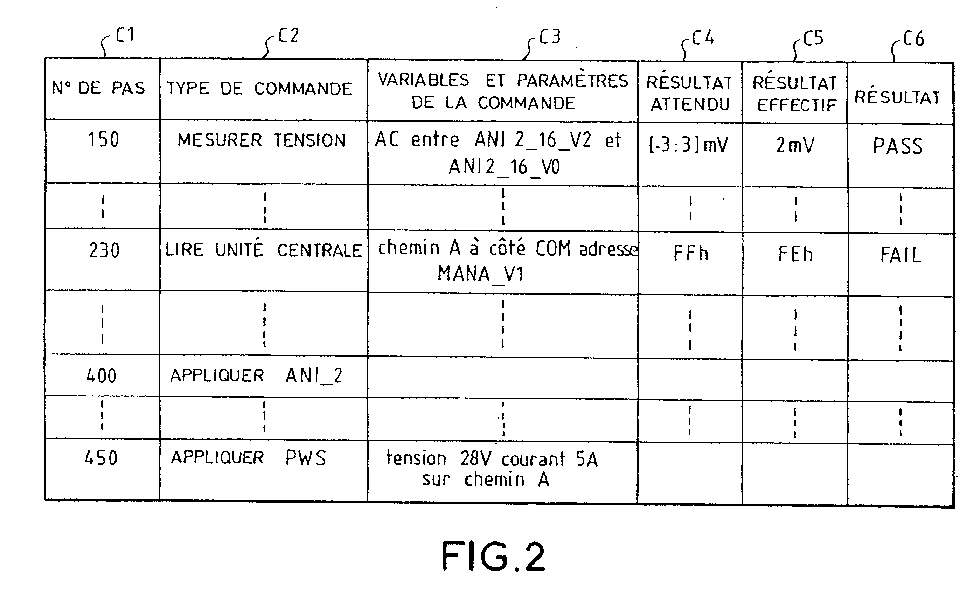

La figure 2 représente schématiquement une feuille de test FOT remplie, après le lancement du test. Dans l'exemple montré, les cellules C1 à C6 d'un groupe sont arrangées en lignes mais elles pourraient être arrangées en colonnes.

Pour au moins une commande, son groupe de cellules comporte une cellule C3 à renseigner avec un libellé de la commande, une cellule C4 à renseigner avec un résultat attendu de la commande, une cellule C5 réservée au résultat effectif de la commande, une cellule C6 réservée au résultat d'une comparaison entre le résultat effectif et le résultat attendu.

Un libellé de commande est associé à un type de commande, il est avantageux de prévoir dans le groupe, une cellule C2 à renseigner avec le type de la commande.

La cellule C3 à renseigner avec le libellé de la commande peut s'étendre sur plusieurs lignes de l'écran E.

Il est avantageux de prévoir dans le groupe de cellules C1 à C6, une cellule C1 de numérotation de la commande ou pas de test. Ce pas peut être utilisé pour repérer facilement une éventuelle erreur de syntaxe ou une commande défaillante.

L'index de l'écran E permet à l'opérateur OP de sélectionner une cellule à renseigner et de saisir son contenu à l'aide des touches du clavier K et/ou de la souris S.

Il existe deux catégories de commandes. Entrent dans la première catégorie les commandes dites "indicateur", elles consistent par exemple à réaliser une mesure ou une lecture, par exemple MESURER TENSION ou LIRE UNITE CENTRALE. Ce type de commande se concrétise par un résultat effectif. Un test possède au moins une commande de cette catégorie.

Entrent dans la seconde catégorie, les commandes dites "de contrôle" consistant à appliquer un signal ou un stimuli à l'équipement sous test, par exemple APPLIQUER ANI-2, APPLIQUER PWS. Ce type de commande n'appelle pas directement de retour du dispositif de test mais est généralement suivi d'une commande "indicateur ".

La saisie d'un type de commande dans une cellule C2 d'un groupe peut être manuelle, mais il est bien préférable d'utiliser les services d'un dictionnaire DICO qui a été chargé au préalable dans le dispositif de test DT. Ce dictionnaire DICO contient une liste des différents types de commandes applicables à l'équipement EQ devant être testé. L'utilisation du dictionnaire DICO fait gagner du temps, simplifie l'intervention de l'opérateur et permet d'éviter l'introduction d'erreurs de syntaxe toujours longues à corriger.

Le libellé associé comporte un ou plusieurs arguments avec une syntaxe prédéfinie. Le dictionnaire DICO contient pour chaque type de commande son libellé associé.

La saisie dans une cellule C2 d'un type de commande fait apparaître dans la cellule C3 correspondante, le libellé de la commande saisie. Le dispositif de test comporte des moyens pour afficher le libellé associé dans la cellule C3 du groupe après le renseignement du type de la commande. Les arguments du libellé sont à compléter par l'opérateur OP.

La liste suivante donne quatre exemples de type de commande et pour chaque type, la syntaxe du libellé associé.
APPLIQUER PWS -----> tension (TENSION) V courant (COURANT)A sur chemin (CHEMIN)
CONNECTER DSI -----> (MASSE/28V) sur <DSI_REF>
MESURER TENSION -----> (AC/DC) entre <SIG+> et <SIG->
APPLIQUER ANI2 -----> <ANI2_VO_REF> V1 = (TENSION) V et V2 = (TENSION) V

Deux types d'arguments sont prévus dans un libellé de commande.

Les paramètres sont indépendants de l'équipement EQ à tester. Un paramètre peut, par exemple, représenter une valeur numérique d'une tension à appliquer, d'un courant à faire circuler, la valeur d'un délai à respecter, le type alternatif ou continu d'un courant etc...

Dans la syntaxe associée aux arguments d'une commande, un paramètre peut s'insérer entre deux parenthèses "( " , " )", par exemple. L'opérateur saisit le paramètre à l'aide du clavier K après avoir placé l'index de l'écran E dans la parenthèse appropriée.

Les variables dépendent de l'équipement électronique EQ à tester. Une variable peut représenter, par exemple, un nom de signal, un nom d'autotest, une adresse logicielle attachée à un autotest de l'équipement électronique EQ à tester. Dans la syntaxe associée aux arguments d'une commande, une variable peut s'insérer entre deux crochets "< " , " >" par exemple.

L'opérateur saisit une variable, à l'aide du clavier K et/ou de la souris S après avoir placé l'index de l'écran E entre les deux crochets appropriés.

Il est prévu de manière avantageuse que les variables soient répertoriées dans au moins une base de données BDV associée à l'équipement à tester EQ. Cette base de donnée BDV facilite la saisie, fait gagner du temps et évite l'introduction d'erreurs de syntaxe.

La base de données BDV regroupe les variables contenues dans les arguments des commandes, notamment celles chargées dans le dictionnaire DICO et pour chaque variable les valeurs qu'elle peut prendre.

Ces valeurs sont exprimées de manière différente selon un identificateur qui correspond au langage de l'opérateur ; ce langage dépend de sa discipline.

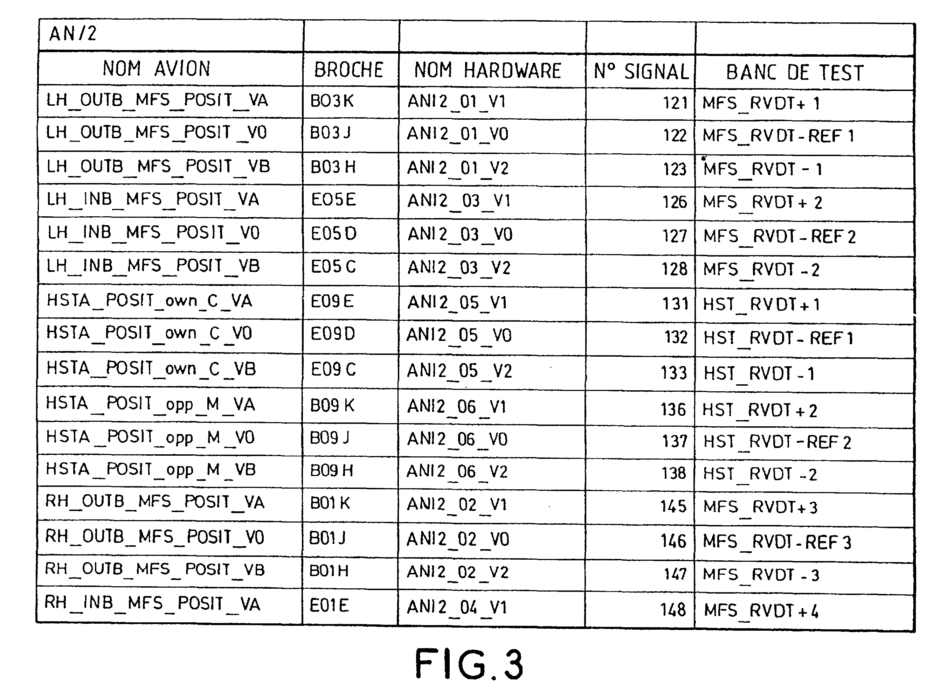

Comme le montre le tableau de la figure 3, la variable ANI2 qui représente un type de signal, peut prendre les valeurs de la première colonne en langage avion pendant la phase de maintenance, les valeurs de la seconde colonne qui représentent des broches de connecteur, les valeurs de la troisième colonne en langage hardware, les valeurs de la quatrième colonne qui représentent des numéros de signaux et enfin les valeurs de la cinquième colonne dans un langage destiné au banc de test BT. Les différentes valeurs sur une même ligne sont équivalentes.

En sélectionnant la cellule C4 d'un groupe, l'opérateur peut saisir s'il y a lieu, le résultat attendu de la commande. Ce résultat peut être saisi sous forme d'une valeur exacte ou d'une plage de valeurs comprise entre crochets. Le résultat attendu est assorti d'une unité ou s'il s'agit d'une adresse exprimée en base hexadécimale de la lettre h.

Sur la figure 2, le résultat attendu au pas 150 est une tension comprise entre -3 et 3 millivolts tandis que celui du pas 230 est une adresse égale à FF en base hexadécimale.

Le numéro de pas de la commande est saisi par l'opérateur après avoir placé l'index dans la cellule C1 correspondante.

Après l'exécution de la commande dont au moins les cellules C2 à C4 ont été saisies, le dispositif de test DT affiche le résultat effectif dans la cellule C5 du groupe puis compare le résultat effectif au résultat attendu afin de déterminer si la commande s'est déroulée correctement. Le résultat de la comparaison ou du pas de test s'affiche dans la cellule C6 correspondante réservée au résultat. Lors du déroulement du test toutes ces commandes sont exécutées séquentiellement quelque soit le résultat de la comparaison.

Le résultat du pas de test peut être symbolisé, par exemple, par les termes anglais PASS ou FAIL.

Le terme PASS est utilisé lorsque le résultat effectif est égal au résultat attendu ou est compris dans la plage. Le terme FAIL est utilisé lorsque le résultat effectif est différent du résultat attendu ou est situé hors de la plage.

Le dispositif de test DT peut être équipé d'un éditeur de texte qui offre à l'opérateur des fonctions permettant d'écrire plus facilement l'ordre de test en réduisant les erreurs.

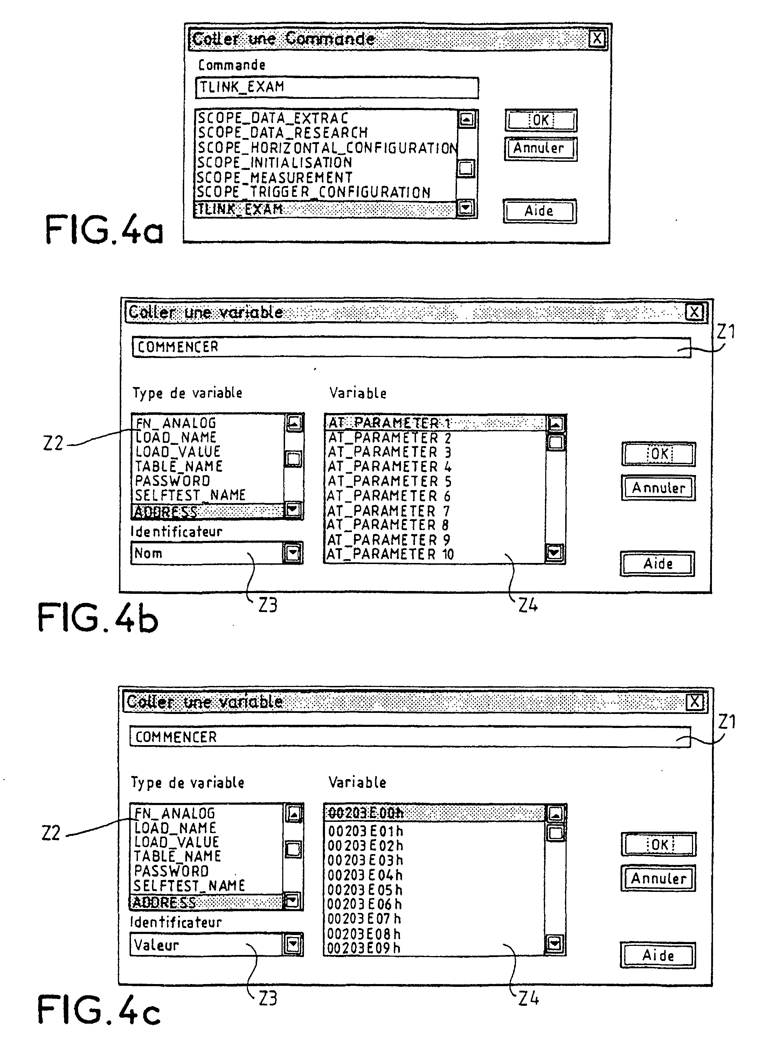

L'une de ses fonctions dénommée "coller une commande" est activée lorsque l'index de l'écran E est dans une cellule C2 à renseigner par le type de commande et que l'opérateur active une touche appropriée de la souris S ou du clavier K. Une fenêtre de dialogue apparaît et propose une liste déroulante de tous les types de commandes contenus dans le dictionnaire DICO. Un exemple de fenêtre est représenté à la figure 4a.

Si la cellule C2 sélectionnée est déjà inscrite, un conflit va apparaître et le dispositif de test DT le détecte. En cas de conflit, l'opérateur en est averti, par exemple, par inversion vidéo de la commande objet du conflit et la fonction éditeur de texte propose soit d'insérer la nouvelle commande avant celle déjà inscrite, soit de remplacer la commande déjà inscrite par la nouvelle.

Lorsque le type de commande est saisi, le libellé de la commande s'inscrit dans la cellule C3 correspondante et l'éditeur de texte ouvre une fenêtre de dénommée "coller une variable" telle que l'une de celles représentées aux figures 4b et 4c. Cette fenêtre présente dans une première zone Z1 le libellé de la commande en cours et ce libellé comporte au moins un argument. En positionnant l'index de l'écran E dans cette zone Z1, l'opérateur peut, si nécessaire, saisir un paramètre. Cette fenêtre présente dans une seconde zone Z2 une liste déroulante de tous les types de variables déclarés pour l'équipement EQ à tester.

Les identificateurs apparaissent dans une troisième zone Z3 de la fenêtre sous forme d'une liste déroulante. Dans l'exemple représenté à la figure 4b, le type de variable dénommé ADDRESS peut s'exprimer sous forme de nom ou comme l'illustre la figure 4c sous forme de valeur.

La fenêtre présente dans une quatrième zone Z4 une liste déroulante des différentes valeurs que peut prendre le type de variable sélectionné en fonction de l'identificateur choisi. Les valeurs d'une variable s'expriment différemment selon l'identificateur choisi par l'opérateur.

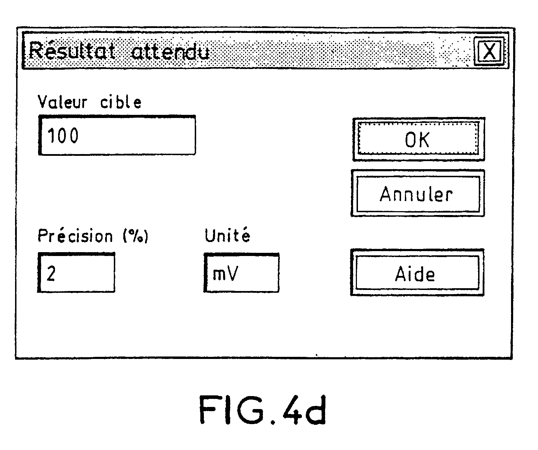

En sélectionnant, si le type de commande saisi l'exige, la cellule C4 du groupe et en activant l'éditeur de texte, une fenêtre de dialogue dénommée "résultat attendu" apparaît. Cette fenêtre, représentée à la figure 4d, comporte la valeur du résultat attendu, la précision reprise et l'unité.

L'opérateur peut ensuite faire exécuter par le dispositif de test DT la commande saisie. Le dispositif de test DT affiche dans la cellule C5 du groupe le résultat effectif et dans la cellule C6 le résultat de la comparaison.

Il est intéressant d'archiver en fin de test les résultats du test. Pour cela le dispositif de test DT comporte au moins une base de données BDR réservée au contenu des cellules d'un groupe. Cet archivage ouvre la possibilité de réaliser des traitements postérieurs sur les résultats archivés. Cet archivage est contractuel pour les tests ATP mais dans les dispositifs de test existants aucune possibilité de traitement n'était prévue.

Le dispositif de test DT peut aussi prévoir une fonction d'analyse syntaxique qui détecte d'éventuelles erreurs de syntaxe dans ce qui a été saisi. En cas d'erreur, cette fonction produit un message d'erreur qui localise l'erreur. Cette fonction d'analyse syntaxique vérifie que le type de commande appartient au dictionnaire DICO, que les arguments ont une syntaxe qui correspond à celle que contient le dictionnaire DICO et que les variables saisies appartiennent à l'une des bases de données BDV. L'opérateur peut alors corriger son erreur.

Le dispositif de test DT peut aussi comporter une fonction de localisation de panne de l'équipement électronique EQ en test.

Cette fonction peut être activée lorsqu'un message "FAIL" est apparu à l'issu de l'exécution d'une commande.

Cette fonction permet de déterminer sur l'équipement électronique EQ en test, notamment à partir du pas de test défaillant, une zone ZCE de l'équipement électronique soupçonnée de panne.

Le dispositif de test DT comporte alors une base de données de localisation de panne BDLP qui recense les résultats des tests précédemment lancés sur d'autres équipements pour lesquels des pannes sont apparues. Un lien est créé entre un pas de test défaillant, le type de commande et la zone de l'équipement mise en cause.

Cette base de données BDLP s'enrichit au fur et à mesure de l'utilisation du dispositif de test DT et de la sauvegarde des résultats de tests.

Cette localisation est réalisée en effectuant une requête à partir du pas défaillant.

De manière à déterminer plus finement dans la zone ZCE le composant électronique CE en panne, il est avantageux que l'opérateur ait à sa disposition un ou plusieurs tests complémentaires à faire passer à l'équipement électronique EQ défaillant.

Il est possible de prévoir une bibliothèque BIBC de tests complémentaires qui conserve des tests complémentaires et cette bibliothèque BIBC est augmentée au fur et à mesure de l'utilisation du dispositif de tests avec de nouveaux tests complémentaires. Ici encore, un test complémentaire est lié à un pas de test défaillant et à un type de commande défaillant.

La bibliothèque BIBC est accessible à l'opérateur quelle que soit sa spécialité.

Les résultats des tests complémentaires peuvent également être sauvegardés dans la base de données des résultats BDR ou dans une base de données BDR' spécifique aux résultats des tests complémentaires.

Le dispositif de test DT peut comporter des moyens de traitement du contenu des cellules sauvegardé dans au moins une des bases de données BDR, BDR'. Il est intéressant de pouvoir faire des analyses statistiques variées. La détermination de la panne la plus fréquente sur un équipement électronique donné peut amener, par exemple, à modifier un composant électronique ou une partie de circuit sur les futurs équipements électroniques de même type. Ces analyses statistiques sont aussi très utiles notamment pour améliorer la maîtrise des procédés de fabrication.

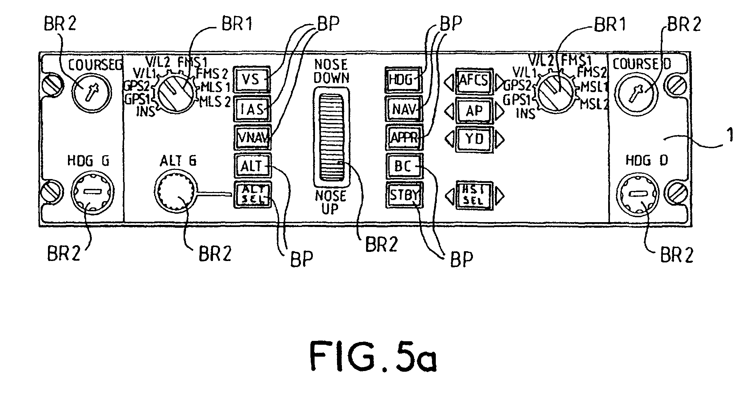

Les tests de certains équipements électroniques EQ ne peuvent avoir lieu de manière totalement automatique. Il s'agit par exemple des postes de commande d'un aéronef dont une partie est représentée à la figure 5a. Pour tester un tel poste, l'opérateur OP est piloté par le dispositif de test DT.

La partie 1 comporte un ou plusieurs organes tels que des boutons poussoirs BP à deux positions et/ou des boutons rotatifs BR1 pouvant prendre plusieurs positions marquées, des boutons rotatifs BR2 pouvant se déplacer en rotation de part et d'autre d'une position généralement centrale. Ces boutons rotatifs BR2 peuvent être des codeurs optiques.

Un tel test est formé d'une alternance de commandes sollicitant à la fois l'opérateur OP et le dispositif de test DT et de commandes ne sollicitant que le dispositif de test DT. Par exemple, un test de poste de pilotage commencera par une commande de type "OUVRIR_POSTE COMMANDE" avec pour argument un paramètre correspondant au nom du poste de commande et comme variable l'identificateur de l'équipement. Cette commande appelle une action manuelle de l'opérateur OP mais également une mesure de la part du dispositif de test DT. La commande suivante de type "DELAI" fixe un délai à l'opérateur OP pour effectuer la commande précédente, ce délai étant décompté par le dispositif de test DT. Les commandes suivantes entraînant une intervention de l'opérateur OP sont de type "ACTION MANUELLE". Leurs arguments précisent la position que l'opérateur doit donner à tel ou tel organe BP, BR1, BR2 du poste. Ce type de commande entraîne aussi une mesure du dispositif de test DT.

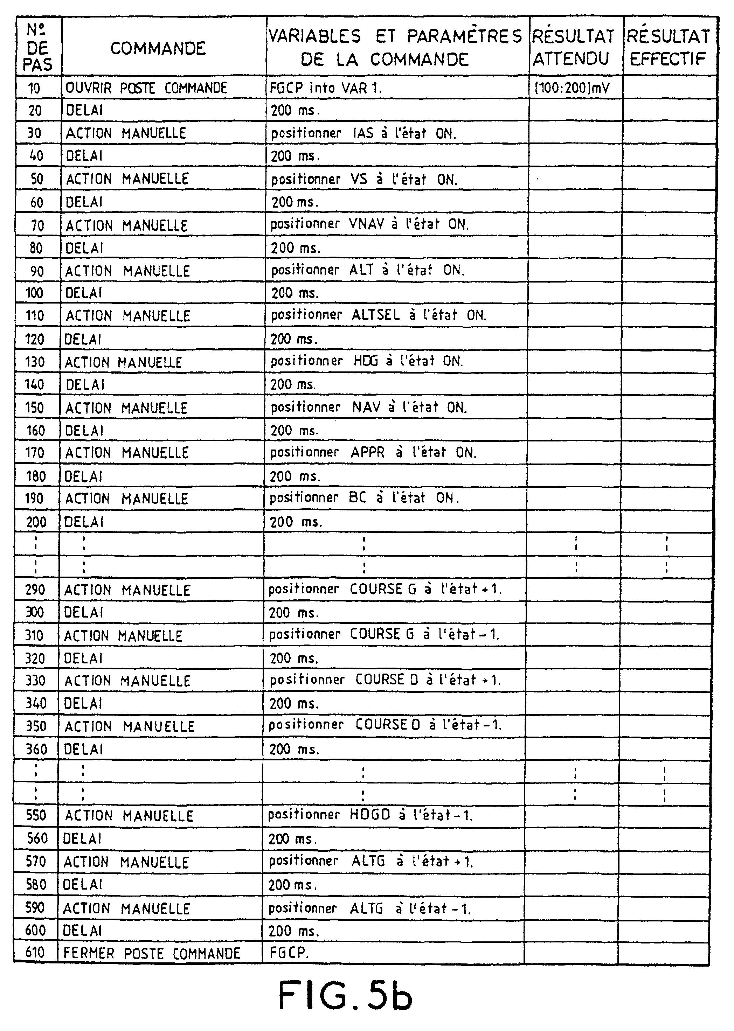

La figure 5b illustre de manière partielle une feuille de test relative à un test de la parte du poste de commande 1 illustré à la figure 5a. Les cellules relatives au résultat de la comparaison ne sont pas représentées.

Entre chaque type de commande sollicitant l'opérateur se place un type de commande fixant un délai à l'opérateur.

Les commandes de type "DELAI" ont pour argument la valeur du délai qui dans l'exemple de la figure 5b est de 200 ms. Le résultat attendu d'une commande de type action manuelle est généralement une valeur de tension ou une plage de tension devant apparaître dans un endroit déterminé lorsque l'organe prend la position indiquée dans le libellé de la commande.

La dernière commande sollicitant l'opérateur est la fermeture du poste de commande et cette commande est suivie du respect d'un délai pour que l'opérateur agisse.

Avant le début de l'exécution d'un tel test, l'écran E du dispositif de test DT affiche une représentation du poste de commande à tester telle que celle de la figure 5a.

Au cours du test, le dispositif de test DT pilote l'opérateur OP en lui indiquant comment et quand actionner les différents organes BR1, BR2, BP du poste de pilotage. Le dispositif de test DT comporte des moyens pour signaler à l'opérateur l'intervention à réaliser en la matérialisant sur la représentation.

Tour à tour les différents organes BP, BR1, BR2 apparaîtront sur l'écran E dans une position particulière et l'opérateur OP aura le délai mentionné dans la commande agir.

Le dispositif de test DT exécute une mesure à l'issu du délai fixé à l'opérateur puis il lui indique une nouvelle action à entreprendre.

Il est avantageux que l'organe à actionner BP, BR1, BR2 apparaisse clairement sur l'écran E de la console IV en surbrillance ou en couleur, par exemple, de manière à faciliter la tâche de l'opérateur.

Après la fermeture du poste de commande, par l'opérateur OP la représentation du poste de commande disparaît et la feuille d'ordre de test FOT correspondant au test qui vient d'être effectué apparaît à l'écran E avec les résultats effectifs et les résultats des comparaisons. La détection des éventuels pas de tests défaillants peut être faite.

## Revendications

1. Procédé de test d'un équipement électronique (EQ) relié à un calculateur (C) couplé à une console d'affichage (IV) et d'entrée de données avec un écran (E) réalisant une interface avec un opérateur (OP), le test comprenant une liste de commandes à exécuter, qui consiste:
• à afficher une feuille de test (FOT) sur l'écran (E) formée de plusieurs groupes de cellules (C1 à C6), un groupe par commande du test,
pour au moins une commande, son groupe associé comportant :
- une cellule (C2) qui est à renseigner avec un type de la commande,
- une cellule (C3) qui est à renseigner avec un libellé de la commande associé au type de la commande, le libellé ayant une syntaxe à respecter et comportant un ou plusieurs arguments devant être complétés par l'opérateur,
- une cellule (C4) qui est à renseigner avec un résultat attendu de la commande,
- une cellule (C5) qui est réservée à un résultat effectif de la commande,
- une cellule (C6) qui est réservée au résultat d'une comparaison entre le résultat effectif et le résultat attendu,
• en cas de sélection d'une cellule (C2) à renseigner avec le type de commande, à donner accès à un dictionnaire (DICO) contenant une liste des types de commandes et pour chaque type le libellé associé,
• le renseignement de la cellule (C2) à renseigner avec le type de commande faisant apparaître le libellé associé dans la cellule (C3) du groupe à renseigner avec le libellé,
• à afficher, après l'exécution de la commande, le résultat effectif et le résultat de la comparaison.

2. Procédé de test selon la revendication 1, **caractérisé en ce qu'**un libellé comporte au moins un argument soit de type paramètre, indépendant de l'équipement électronique (EQ) à tester, soit de type variable, dépendant de l'équipement électronique (EQ) à tester.

3. Procédé de test selon la revendication 2, **caractérisé en ce qu'**il consiste en cas de sélection d'une cellule (C3) à renseigner avec un libellé de commande, ayant un argument de type variable, à autoriser l'accès à au moins une base de données (BDV) associant la variable à des valeurs qu'elle peut prendre.

4. Procédé de test selon la revendication 3, **caractérisé en ce que** les valeurs d'une variable s'expriment différemment selon un identificateur à choisir par l'opérateur .

5. Procédé de test selon l'une des revendications 1 à 4, **caractérisé en ce qu'**il consiste à numéroter les commandes du test et à prévoir dans le groupe de cellules associé à une commande une cellule à renseigner avec son pas.

6. Procédé de test selon l'une des revendications 1 à 5, **caractérisé en ce qu'**il consiste à proposer une sauvegarde du contenu des cellules (C1 à C6) du groupe après l'exécution de la commande.

7. Procédé de test selon la revendication 6, **caractérisé en ce qu'**il consiste à proposer au moins un traitement du contenu sauvegardé notamment à des fins statistiques.

8. Procédé de test selon l'une des revendications 1 à 7, **caractérisé en ce qu'**il consiste à exécuter toutes les commandes du test quel que soit le résultat des comparaisons.

9. Procédé de test selon l'une des revendications 1 à 8, **caractérisé en ce qu'**il consiste, en cas de différence entre le résultat effectif et le résultat attendu de la commande, à proposer un accès à au moins un test complémentaire contenu dans une bibliothèque (BIBC) destinée à conserver des tests complémentaires.

10. Procédé de test selon l'une des revendications 1 à 9, **caractérisé en ce qu'**il consiste, en cas de différence entre le résultat effectif et le résultat attendu de la commande, à proposer l'accès à une base de données (BDLP) de localisation de panne, cette base de données regroupant des sauvegardes de commandes relatives à des équipements électroniques précédemment testés dont au moins une zone (ZCE) présentait une défaillance, et établissant un lien entre la zone défaillante et au moins une commande pour laquelle existe une différence entre le résultat effectif et le résultat attendu.

11. Procédé de test selon l'une des revendications 1 à 10, **caractérisé en ce qu'**il consiste à afficher sur l'écran (E) une représentation d'au moins une partie de l'équipement à tester (EQ) lorsqu'une intervention de l'opérateur est nécessaire pour réaliser le test, et à signaler à l'opérateur l'intervention à réaliser en la matérialisant sur la représentation.

12. Dispositif de test d'un équipement électronique (EQ) comportant un calculateur (C) relié à l'équipement électronique (EQ), couplé à une console d'affichage (IV) et d'entrée de données avec, un écran (E), réalisant une interface avec un opérateur (OP), le test comportant une liste de commandes à exécuter,
• l'écran (E) étant prévu pour afficher une feuille de test (FOT) formée de plusieurs groupes de cellules (C1 à C6), un groupe par commande du test, et pour au moins une commande, son groupe de cellules (C1 à C6) comportant :
- une cellule (C2) à renseigner avec un type de la commande,
- une cellule (C3) à renseigner avec un libellé de la commande, le libellé ayant une syntaxe à respecter et comportant un ou plusieurs arguments devant être complétés par l'opérateur,
- une cellule (C4) à renseigner avec un résultat attendu de la commande,
- une cellule (C5) réservée à un résultat effectif de la commande,
- une cellule (C6) réservée au résultat d'une comparaison entre le résultat effectif et le résultat attendu,
• le dispositif comportant :
- un dictionnaire (DICO) contenant une liste des types de commandes et pour chaque type le libellé associé utilisable pour renseigner la cellule (C2) à renseigner avec le type de la commande,
- des moyens pour, lorsque la cellule (C2) à renseigner avec le type de la commande est renseignée, afficher le libellé associé dans la cellule (C3) du groupe à renseigner avec le libellé,
- et des moyens pour afficher le résultat effectif et le résultat de la comparaison à l'issu de l'exécution de la commande.

13. Dispositif de test selon la revendication 12, **caractérisé en ce qu'**il comporte au moins une base de données (BDV) regroupant pour une variable les valeurs qu'elle peut prendre.

14. Dispositif de test selon la revendication 13, **caractérisé en ce que** la base de données contient les valeurs d'une variable exprimées de manières différentes selon un identificateur à choisir par l'opérateur.

15. Dispositif de test selon l'une des revendications 12 à 14, **caractérisé en ce que** le groupe de cellules (C1 à C6) associé à une commande comporte en outre une cellule (C1) à renseigner avec un pas attribué à la commande.

16. Dispositif de test selon l'une des revendications 12 à 15, **caractérisé en ce qu'**il comporte au moins une base de données (BDR) de sauvegarde du contenu des cellules d'un groupe après l'exécution de la commande.

17. Dispositif de test selon la revendication 16, **caractérisé en ce qu'**il comporte des moyens de traitement du contenu sauvegardé notamment à des fins statistiques.

18. Dispositif de test selon l'une des revendications 12 à 17, **caractérisé en ce qu'**il comporte une bibliothèque (BIBC) destinée à conserver des tests complémentaires, utilisable en cas de différence entre le résultat effectif et le résultat attendu de la commande.

19. Dispositif de test selon l'une des revendications 12 à 18, **caractérisé en ce qu'**il comporte une base de données (BDLP) de localisation de panne, utilisable en cas de différence entre le résultat effectif et le résultat attendu de la commande, cette base de données regroupant des sauvegardes de commandes relatives à des équipements électroniques précédemment testés dont au moins une zone (ZCE) présentant une défaillance et établissant un lien entre la zone défaillante et au moins une commande pour laquelle existe une différence entre le résultat effectif et le résultat attendu.

20. Dispositif de test selon l'une des revendications 12 à 19, **caractérisé en ce qu'**il comporte des moyens d'affichage sur l'écran (E) d'une représentation d'au moins une partie (1) de l'équipement à tester, lorsque l'intervention de l'opérateur est nécessaire pour réaliser le test, et des moyens pour signaler à l'opérateur l'intervention à réaliser en la matérialisant sur la représentation.

21. Dispositif de test selon l'une des revendications 12 à 20, **caractérisé en ce qu'**il comporte un éditeur de test comportant au moins une fenêtre de dialogue proposant un menu déroulant pour aider au renseignement d'au moins cellule du groupe.

## Patentansprüche

1. Verfahren zum Prüfen einer elektronischen Anlage (EQ), die mit einem Rechner (C) verbunden ist, der mit einer Anzeige- und Dateneingabekonsole (IV) mit Bildschirm (E), die eine Schnittstelle mit einer Bedienungsperson (OP) bildet, gekoppelt ist, wobei die Prüfung eine Liste von auszuführenden Befehlen umfaßt, wobei das Verfahren darin besteht:
■ auf dem Bildschirm (E) ein Prüfblatt (FOT) anzuzeigen, das aus mehreren Gruppen von Zellen (C1 bis C6), eine Gruppe pro Prüfbefehl, gebildet ist,
wobei für wenigstens einen Befehl dessen zugeordnete Gruppe umfaßt:
- eine Zelle (C2), in die der Typ des Befehls einzutragen ist,
- eine Zelle (C3), in die ein Etikett des Befehls, das dem Typ des Befehls zugeordnet ist, einzutragen ist, wobei das Etikett eine zu berücksichtende Syntax besitzt und ein oder mehrere Argumente enthält, die von der Bedienungsperson vervollständigt werden müssen,
- eine Zelle (C4), in die das erwartete Resultat des Befehls einzutragen ist,
- eine Zelle (C5), die einem effektiven Resultat des Befehls vorbehalten ist,
- eine Zelle (C6), die dem Resultat eines Vergleichs zwischen dem effektiven Resultat und dem erwarteten Resultat vorbehalten ist,
■ wenn eine Zelle (C2) gewählt wird, in die der Typ des Befehls einzutragen ist, Zugriff auf ein Lexikon (DICO) zu gewähren, das eine Liste der Typen von Befehlen und für jeden Typ das zugeordnete Etikett enthält,
■ wobei der Eintrag der Zelle (C2), in die der Befehlstyp einzutragen ist, das zugeordnete Etikett in derjenigen Zelle (C3) der Gruppe, in die das Etikett einzutragen ist, erkennen läßt,
■ nach der Ausführung des Befehls das effektive Resultat und das Vergleichsresultat anzuzeigen.

2. Prüfverfahren nach Anspruch 1, **dadurch gekennzeichnet, daß** ein Etikett wenigstens ein Argument entweder vom Parametertyp, der von der zu prüfenden elektronischen Anlage (EQ) unabhängig ist, oder vom Variablentyp, der von der zu prüfenden elektronischen Anlage (EQ) abhängt, umfaßt.

3. Prüfverfahren nach Anspruch 2, **dadurch gekennzeichnet, daß** es dann, wenn eine Zelle (C3) gewählt wird, in die ein Befehlsetikett einzutragen ist, das ein Argument des Variablentyps besitzt, darin besteht, den Zugriff auf wenigstens eine Datenbank (BDV) zuzulassen, die der Variablen Werte zuordnet, die sie annehmen kann.

4. Prüfverfahren nach Anspruch 3, **dadurch gekennzeichnet, daß** die Werte einer Variablen je nach einem von der Bedienungsperson zu wählenden Identifizierer unterschiedlich dargestellt werden.

5. Prüfverfahren nach einem der Ansprüche 1 bis 4, **dadurch gekennzeichnet, daß** es darin besteht, die Prüfbefehle zu numerieren und in der Gruppe der Zellen, die einem Befehl zugeordnet sind, eine Zelle vorzusehen, in die seine Schrittnummer einzutragen ist.

6. Prüfverfahren nach einem der Ansprüche 1 bis 5, **dadurch gekennzeichnet, daß** es darin besteht, eine Sicherung des Inhalts der Zellen (C1 bis C6) der Gruppe nach der Ausführung des Befehls vorzuschlagen.

7. Prüfverfahren nach Anspruch 6, **dadurch gekennzeichnet, daß** es darin besteht, wenigstens eine Verarbeitung des gesicherten Inhalts insbesondere für statistische Zwecke vorzuschlagen.

8. Prüfverfahren nach einem der Ansprüche 1 bis 7, **dadurch gekennzeichnet, daß** es darin besteht, alle Befehle der Prüfung unabhängig vom Resultat der Vergleiche auszuführen.

9. Prüfverfahren nach einem der Ansprüche 1 bis 8, **dadurch gekennzeichnet, daß** es im Fall einer Differenz zwischen dem effektiven Resultat und dem erwarteten Resultat des Befehls darin besteht, einen Zugriff auf wenigstens eine zusätzliche Prüfung vorzuschlagen, die in der Bibliothek (BIBC) enthalten ist, die dazu bestimmt ist, zusätzliche Prüfungen aufzubewahren.

10. Prüfverfahren nach einem der Ansprüche 1 bis 9, **dadurch gekennzeichnet, daß** es im Fall einer Differenz zwischen dem effektiven Resultat und dem erwarteten Resultat des Befehls darin besteht, den Zugriff auf eine Datenbank (BDLP) zur Fehlerlokalisierung vorzuschlagen, wobei diese Datenbank die Sicherungen von Befehlen bezüglich der früher geprüften elektronischen Anlagen umgruppiert, von denen wenigstens eine Zone (ZCE) eine Störung aufwies, und eine Verbindung zwischen der gestörten Zone und wenigstens einem Befehl, für den eine Differenz zwischen dem effektiven Resultat und dem erwarteten Resultat vorhanden ist, erstellt.

11. Prüfverfahren nach einem der Ansprüche 1 bis 10, **dadurch gekennzeichnet, daß** es darin besteht, auf dem Bildschirm (E) eine Darstellung wenigstens eines Teils der zu prüfenden Anlage (EQ) anzuzeigen, wenn ein Eingriff der Bedienungsperson erforderlich ist, um die Prüfung auszuführen, und der Bedienungsperson den auszuführenden Eingriff zu melden, indem dieser in der Darstellung angegeben wird.

12. Vorrichtung zum Prüfen einer elektronischen Anlage (EQ), die einen Rechner (C) umfaßt, der mit der elektronischen Anlage (EQ) verbunden ist und mit einer Anzeige- und Dateneingabekonsole mit Bildschirm (E) gekoppelt ist, die eine Schnittstelle mit einer Bedienungsperson (OP) bildet, wobei die Prüfung eine Liste von auszuführenden Befehlen umfaßt,
■ wobei der Bildschirm (E) dazu vorgesehen ist, ein Prüfblatt (FOT) anzuzeigen, das aus mehreren Gruppen von Zellen (C1 bis C6), eine Gruppe pro Befehl der Prüfung, gebildet ist, wobei für wenigstens einen Befehl dessen Gruppe von Zellen (C1 bis C6) umfaßt:
- eine Zelle (C2), in die ein Typ des Befehls einzutragen ist,
- eine Zelle (C3), in die ein Etikett des Befehls einzutragen ist, wobei das Etikett eine zu berücksichtigende Syntax besitzt und ein oder mehrere Argumente enthält, die von der Bedienungsperson vervollständigt werden müssen,
- eine Zelle (C4), in die das erwartete Resultat des Befehls einzutragen ist,
- eine Zelle (C5), die einem effektiven Resultat des Befehls vorbehalten ist,
- eine Zelle (C6), die dem Resultat eines Vergleichs zwischen dem effektiven Resultat und dem erwarteten Resultat vorbehalten ist,
■ wobei die Vorrichtung umfaßt:
- ein Lexikon (DICO), das eine Liste von Typen von Befehlen und für jeden Typ das zugeordnete Etikett enthält, das dazu verwendbar ist, die Zelle (C2), in die der Befehlstyp einzutragen ist, auszufüllen,
- Mittel, die dann, wenn die Zelle (C2), in die der Befehlstyp einzutragen ist, ausgefüllt ist, das zugeordnete Etikett derjenigen Zelle (C3) der Gruppe, in die das Etikett einzutragen ist, anzeigen,
- und Mittel, die das effektive Resultat und das Resultat des Vergleichs nach dem Abschluß der Ausführung des Befehls anzeigen.

13. Prüfvorrichtung nach Anspruch 12, **dadurch gekennzeichnet, daß** sie wenigstens eine Datenbank (BDV) umfaßt, die für eine Variable die Werte, die sie annehmen kann, umgruppiert.

14. Prüfvorrichtung nach Anspruch 13, **dadurch gekennzeichnet, daß** die Datenbank die Werte einer Variable enthält, die entsprechend einem von der Bedienungsperson zu wählenden Identifizierer unterschiedlich dargestellt werden.

15. Prüfvorrichtung nach einem der Ansprüche 12 bis 14, **dadurch gekennzeichnet, daß** die Gruppe von Zellen (C1 bis C6), die einem Befehl zugeordnet ist, außerdem eine Zelle (C1) umfaßt, in die eine dem Befehl zugewiesene Schrittnummer einzutragen ist.

16. Prüfvorrichtung nach einem der Ansprüche 12 bis 15, **dadurch gekennzeichnet, daß** sie wenigstens eine Datenbank (BDR) für die Sicherung des Inhalts der Zellen einer Gruppe nach der Ausführung des Befehls umfaßt.

17. Prüfvorrichtung nach Anspruch 16, **dadurch gekennzeichnet, daß** sie Mittel für die Verarbeitung des gesicherten Inhalts insbesondere zu statistischen Zwecken umfaßt.

18. Prüfvorrichtung nach einem der Ansprüche 12 bis 17, **dadurch gekennzeichnet, daß** sie eine Bibliothek (BIBC) umfaßt, die dazu bestimmt ist, zusätzliche Prüfungen aufzubewahren, und die im Fall einer Differenz zwischen dem effektiven Resultat und dem erwarteten Resultat des Befehls verwendbar ist.

19. Prüfvorrichtung nach einem der Ansprüche 12 bis 18, **dadurch gekennzeichnet, daß** sie eine Datenbank (BDLP) zur Lokalisierung eines Fehlers umfaßt, die im Fall einer Differenz zwischen dem effektiven Resultat und dem erwarteten Resultat des Befehls verwendbar ist, wobei diese Datenbank die Sicherungen von Befehlen bezüglich früher geprüfter elektronischer Anlagen umgruppiert, von denen wenigstens eine Zone (ZCE) eine Störung aufweist, und eine Verbindung zwischen der gestörten Zone und wenigstens einem Befehl, für den eine Differenz zwischen dem effektiven Resultat und dem erwarteten Resultat vorhanden ist, erstellt.

20. Prüfvorrichtung nach einem der Ansprüche 12 bis 19, **dadurch gekennzeichnet, daß** sie Mittel, die auf dem Bildschirm (E) eine Darstellung wenigstens eines Teils (1) der zu prüfenden Anlage anzeigen, wenn ein Eingriff der Bedienungsperson für die Ausführung der Prüfung notwendig ist, sowie Mittel umfaßt, die der Bedienungsperson den auszuführenden Eingriff melden, indem sie ihn in der Darstellung anzeigen.

21. Prüfvorrichtung nach einem der Ansprüche 12 bis 20, **dadurch gekennzeichnet, daß** sie einen Prüfeditor umfaßt, der wenigstens ein Dialogfenster enthält, das ein Dropdown-Menü vorschlägt, um die Informationen wenigstens einer Zelle der Gruppe zu unterstützen.

## Claims

1. Process for testing an electronic equipment (EQ) linked to a computer (C) coupled to a data entry and display console (IV) with a screen (E) effecting an interface with an operator (OP), the test comprising a list of commands to be executed, which consists:
• in displaying a test chart (FOT) on the screen (E), made up of several groups of cells (C1 to C6), one group per command of the test,
- for at least one command, its associated group including:
- a cell (C2) which is to be supplied with a type of the command,
- a cell (C3) which is to be supplied with a label of the command, which label is associated with the type of the command, the label having a syntax to be complied with and including one or more arguments having to be completed by the operator,
- a cell (C4) which is to be supplied with an expected result of the command,
- a cell (C5) which is reserved for an actual result of the command,
- a cell (C6) which is reserved for the result of a comparison between the actual result and the expected result,
• in the event of selecting a cell (C2) to be supplied with the command type, in affording access to a dictionary (DICO) containing a list of command types and for each type the associated label,
• the supplying of the cell (C2) to be supplied with the command type causing the associated label to appear in the cell (C3) of the group to be supplied with the label,
• in displaying, after the execution of the command, the actual result and the result of the comparison.

2. Test process according to one of Claim 1, **characterized in that** a label includes at least one argument either of parameter type, independent of the electronic equipment (EQ) to be tested, or of variable type, dependent on the electronic equipment (EQ) to be tested.

3. Test process according to Claim 2, **characterized in that** it consists, in the event of selecting a cell (C3) to be supplied with a command label, having an argument of variable type, in authorizing access to at least one database (BDV) associating the variable with values which it can take.

4. Test process according to Claim 3, **characterized in that** the values of a variable are expressed differently according to an identifier to be chosen by the operator.

5. Test process according to one of Claims 1 to 4, **characterized in that** it consists in numbering the commands of the test and in providing within the group of cells associated with a command a cell to be supplied with its step.

6. Test process according to one of Claims 1 to 5, **characterized in that** it consists in proposing a saving of the contents of the cells (C1 to C6) of the group after the execution of the command.

7. Test process according to Claim 6, **characterized in that** it consists in proposing at least one processing of the saved contents especially for statistical purposes.

8. Test process according to one of Claims 1 to 7, **characterized in that** it consists in executing all the commands of the test regardless of the result of the comparisons.

9. Test process according to one of Claims 1 to 8, **characterized in that** it consists, in the event of a difference between the actual result and the expected result of the command, in proposing an access to at least one complementary test contained in a library (BIBC) intended for holding complementary tests.

10. Test process according to one of Claims 1 to 9, **characterized in that** it consists, in the event of a difference between the actual result and the expected result of the command, in proposing access to a fault-locating database (BDLP), this database grouping together saves of commands relating to electronic equipments previously tested, at least one zone (ZCE) of which exhibited a defect, and establishing a link between the defective zone and at least one command for which a difference exists between the actual result and the expected result.

11. Test process according to one of Claims 1 to 10, **characterized in that** it consists in displaying on the screen (E) a representation of at least one part of the equipment to be tested (EQ) when an intervention by the operator is necessary to carry out the test, and in signalling to the operator the intervention to be carried out by depicting it on the representation.

12. Test device for an electronic equipment (EQ) including a computer (C) linked to an electronic equipment (EQ), coupled to a data entry and display console (IV) with, a screen (E), effecting an interface with an operator (OP), the test including a list of commands to be executed,
• the screen (E) being provided for displaying a test chart (FOT) made up of several groups of cells (C1 to C6), one group per command of the test, and for at least one command, its group of cells (C1 to C6) including:
- a cell (C2) which is to be supplied with a type of the command,
- a cell (C3) which is to be supplied with a label of the command, the label having a syntax to be complied with and including one or more arguments having to be completed by the operator,
- a cell (C4) which is to be supplied with an expected result of the command,
- a cell (C5) which is reserved for an actual result of the command,
- a cell (C6) which is reserved for the result of a comparison between the actual result and the expected result,
• the device including:
- a dictionary (DICO) containing a list of command types and for each type the associated label usable to supply the cell (C2) to be supplied with the type of the command,
- means for, when the cell (C2) to be supplied with the type of the command is supplied, displaying the associated label in the cell (C3) of the group to be supplied with the label,
- and means for displaying the actual result and the result of the comparison on completion of the execution of the command.

13. Test device according to Claim 12, **characterized in that** it includes at least one database (BDV) grouping together for one variable the values which it can take.

14. Test device according to Claim 13, **characterized in that** the database contains the values of a variable which are expressed in different ways according to an identifier to be chosen by the operator.

15. Test device according to one of Claims 12 to 14, **characterized in that** the group of cells (C1 to C6) associated with a command furthermore includes a cell (C1) to be supplied with a step allocated to the command.

16. Test device according to one of Claims 12 to 15, **characterized in that** it includes at least one database (BDR) for saving the contents of the cells of a group after the execution of the command.

17. Test device according to Claim 16, **characterized in that** it includes means for processing the saved contents especially for statistical purposes.

18. Test device according to one of Claims 12 to 17, **characterized in that** it includes a library (BIBC) intended for holding complementary tests, usable in the event of a difference between the actual result and the expected result of the command.

19. Test device according to one of Claims 12 to 18, **characterized in that** it includes a fault-locating database (BDLP), usable in the event of a difference between the actual result and the expected result of the command, this database grouping together saves of commands relating to electronic equipments previously tested, at least one zone (ZCE) of which exhibiting a defect and establishing a link between the defective zone and at least one command for which a difference exists between the actual result and the expected result.

20. Test device according to one of Claims 12 to 19, **characterized in that** it includes means for displaying on the screen (E) a representation of at least one part (1) of the equipment to be tested, when the intervention by the operator is necessary to carry out the test, and means for signalling to the operator the intervention to be carried out by depicting it on the representation.

21. Test device according to one of Claims 12 to 20, **characterized in that** it includes a test editor including at least one dialogue window proposing a dropdown menu for aiding the supplying of at least one cell of the group.
